# FASCICULE DE BREVET EUROPEEN

(11) **EP 3 526 375 B1**
(45) Date de publication et mention de la délivrance du brevet: **24.06.2020**
(21) Numéro de dépôt: 17794372.7
(22) Date de dépôt: 11.10.2017
(51) Int. Cl.: C30B 7/14, C30B 29/02, C30B 29/60

(54) **SYNTHESE DE NANOPARTICULES COEUR-COQUILLE ET APPLICATIONS DE CES NANOPARTICULES POUR LA SPECTROSCOPIE RAMAN EXALTEE DE SURFACE**
SYNTHESE VON KERN-SCHALEN-NANOPARTIKELN UND VERWENDUNG DIESER NANOPARTIKEL FÜR OBERFLÄCHENVERSTÄRKTE RAMAN-SPEKTROSKOPIE
SYNTHESIS OF CORE-SHELL NANOPARTICLES AND USES OF SAID NANOPARTICLES FOR SURFACE-ENHANCED RAMAN SPECTROSCOPY

(30) Priorité: 13.10.2016 FR 1659934
(43) Date de publication de la demande: 21.08.2019
(73) Titulaire: Université Paris Diderot, 75013 Paris (FR); Centre National de la Recherche Scientifique, 75794 Paris (FR); Institut De Physique Du Globe De Paris, 75005 Paris (FR)
(72) Inventeur: HAIDAR, Israa, 75014 Paris (FR); NEUVILLE, Daniel, 93100 Montreuil (FR); BOUBEKEUR, Leïla, 94000 Créteil (FR); FELIDJ, Nordin, 92300 Levallois-Perret (FR)
(74) Mandataire: Demulsant, Xavier
(86) Numéro de dépôt international: PCT/FR2017/052798
(87) Numéro de publication internationale: WO 2018/069646

(56) Documents cités:
- US-A1- 2006 207 388
- BORIS N. KHLEBTSOV ET AL: "Surface-Enhanced Raman Scattering Substrates Based on Self-Assembled PEGylated Gold and Gold-Silver Core-Shell Nanorods", JOURNAL OF PHYSICAL CHEMISTRY C, vol. 117, no. 44, 1 janvier 2013 (2013-01-01), pages 23162-23171, XP055326436, US ISSN: 1932-7447, DOI: 10.1021/jp408359p
- RANDA AHMAD ET AL: "Tailoring the Surface Chemistry of Gold Nanorods through Au-C/Ag-C Covalent Bonds Using Aryl Diazonium Salts", JOURNAL OF PHYSICAL CHEMISTRY C, vol. 118, no. 33, 21 août 2014 (2014-08-21), pages 19098-19105, XP055377498, US ISSN: 1932-7447, DOI: 10.1021/jp504040d
- N. FÉLIDJ ET AL: "Morphology of Silver and Gold "SERS Active" Substrates from Optical Spectroscopy Experiments and Numerical Simulations", PHYSICA STATUS SOLIDI (A). APPLIED RESEARCH, vol. 175, no. 1, 1 septembre 1999 (1999-09-01), pages 367-372, XP055429297, DE ISSN: 0031-8965, DOI: 10.1002/(SICI)1521-396X(199909)175:1<367:: AID-PSSA367>3.0.CO;2-2
- LILI FENG ET AL: "Preparation of gold nanorods with different aspect ratio and the optical response to solution refractive index", JOURNAL OF EXPERIMENTAL NANOSCIENCE, vol. 10, no. 4, 25 août 2013 (2013-08-25), pages 258-267, XP055264271, GB ISSN: 1745-8080, DOI: 10.1080/17458080.2013.824619

## Description

### Domaine technique

L'invention a trait à la synthèse de nanoparticules métalliques de type cœur-coquille, par une approche de type bottom-up, à partir d'une solution colloïdale.

L'invention trouve des applications avantageuses pour la réalisation de substrats pour la spectroscopie Raman exaltée de surface (*Surface Enhanced Raman Scattering* SERS).

### Définitions

Par « substrat pour la spectroscopie Raman exaltée de surface », on désigne ici un support, par exemple en silicium, sur lequel est placée une solution contenant des nanoparticules métalliques.

Par « nanoparticule » on désigne ici un ensemble d'édifices polyatomiques de taille nanométrique, typiquement variant entre 1 et 200 nm, quelle que soit l'une des trois dimensions.

Par « nanoparticules métalliques » on désigne ici notamment les nanoparticules de métaux nobles, et en particulier l'or et l'argent.

Par « nanoparticules métalliques de type cœur-coquille », on désigne ici des nanoparticules formées d'un cœur en un premier métal noble, en particulier l'or, enrobé d'une coquille en un deuxième métal noble, en particulier l'argent.

### Etat de la technique

Les méthodes de synthèse des nanoparticules métalliques peuvent être classées en deux groupes : « top-down » et « bottom-up ».

Les approches « top-down » permettent de partir du matériau massif, puis le réduire en composés de plus en plus fins, par exemple par voie électrochimique, ablation laser en phase aqueuse, broyage de poudres, lithographie. Des nanoparticules d'or ont été produites par ablation laser dans l'eau, ou bien encore dans l'acétone, le toluène, le tétrahydrofurane, l'acétonitrile. Amendola et al (Synthetic metals, Vol 155, Issue 2, 2005, pp. 283-286) décrivent l'ablation laser dans le diméthulsulfoxyde (DMSO, CAS 67-68-5), permettant la fonctionnalisation des nanoparticules d'or par des dérivés de fullerènes.

Les approches « bottom-up » partent des entités chimiques les plus petits possibles, comme les atomes ou les molécules qui s'assemblent, pour former progressivement une nanoparticule. Les approches bottom-up mettent typiquement en oeuvre des réactions de réduction ou de décomposition, en phase gazeuse, liquide ou solide, par voie physique (pyrolyse laser, dépôt CVD), ou par voie chimique (réduction chimique, électrochimique, photochimique, procédés sol-gel).

La spectroscopie Raman exaltée de surface (SERS) repose principalement sur l'utilisation de substrats SERS (à base de métaux en général : Au, Ag, Cu) ayant des propriétés optiques singulières, liées à l'excitation par la lumière de plasmons de surface localisés (*Localized Surface Plasmon Resonance* LSPR).

Typiquement, un substrat SERS se présente sous forme de nanoparticules métalliques (en solution ou déposées sur support solide) ou de film métallique rugueux déposé sur surface plane (lame de verre, silicium).

Les substrats SERS peuvent être actifs ou passifs, les substrats actifs permettant une sélectivité du substrat, par une fonctionnalisation, par exemple utilisation d'un antigène pour la détection d'un anticorps.

Les caractéristiques vibrationnelles des molécules obtenues par diffusion Raman sont généralement très faibles, mais en présence de nanoparticules de métaux nobles, ces signaux sont considérablement amplifiés.

Les molécules adsorbées à la surface des nanoparticules métalliques subissent un effet SERS, en raison du fort champ électromagnétique subi par les molécules au voisinage de la surface du métal. Le confinement de champ au plus proche du métal résulte de l'excitation des plasmons de surface localisés.

La spectroscopie Raman exaltée de surface (SERS) est ainsi devenue une spectroscopie vibrationnelle incontournable, en s'ouvrant à des domaines aussi variés que la biologie, la chimie analytique, l'identification, la conservation et restauration d'oeuvres d'art, ou la criminalistique.

Les applications du SERS sont typiquement celles dans lesquelles la concentration du composé à détecter est basse, par rapport à la sensibilité du Raman (par exemple identification de contaminants, de polluants, de liquides biologiques lors d'investigations de police scientifique), ou lorsque les analyses sont difficiles sans préparation (identification de micro-organismes pour l'industrie agroalimentaire ou l'hygiène médicale, imagerie cellulaire), ou bien encore pour les diagnostics médicaux.

A titre d'illustration, le SERS est ainsi proposé pour la détection de prise de drogue (par ex. Nuntawong et al, Detection of methamphetamine/amphetamine in human urine based on surface-enhanced Raman spectroscopy and acidulation treatments, Sensors and Actuators B: Chemical, Volume 239, 2017, Pages 139-146), la détection d'explosifs, de polluants tels que pesticides ou métaux lourds (par exemple le mercure, Sun et al, Recent progress in detection of mercury using surface enhanced Raman spectroscopy- A review, Journal of Environmental Sciences, Volume 39, 2016, Pages 134-143).

Le SERS, longtemps considéré comme un phénomène physique remarquable mais purement fondamental, s'est imposé peu à peu comme un outil analytique robuste et efficace pour exalter (au sens d'amplifier) de plusieurs ordres de grandeurs (10³-10⁷) le signal Raman des molécules.

### Problèmes techniques

La réalisation de substrats SERS est complexe.

Comme mentionné plus haut, l'exaltation Raman est gouvernée par l'excitation des plasmons LSPR, ce qui suppose une bonne adéquation entre la longueur d'onde d'excitation laser (Raman) et la position de la résonance plasmon.

Pour des nanoparticules métalliques sphériques, la position et la largeur de la bande plasmon est influencée par la taille des nanoparticules. Par ailleurs, le mode d'oscillation des électrons de surface d'une particule est propre à sa géométrie. Une particule isotrope, comme par exemple une particule sphérique, aura un seul mode, alors qu'une particule complexe ou anisotrope (par exemple un bâtonnet) aura plus d'un mode de résonance plasmon. Une particule de forme bâtonnet ou ellipsoïdale, aura deux modes de résonance des électrons : une composante transversale, liée au diamètre, et une composante longitudinale, liée à la longueur du bâtonnet. Pour des nanoparticules métalliques en forme de bâtonnet, le rapport d'aspect des nanoparticules (longueur/diamètre) a une influence sur la bande plasmon correspondant à la composante longitudinale. La dispersion des nanoparticules a également une influence, par couplage entre les modes résonants de nanoparticules voisines.

La génération de plasmons de surface localisés, responsable de l'augmentation de l'interaction entre la lumière monochromatique générée par un laser et une molécule sonde, est liée à la présence dans le substrat de « points chauds », cette expression désignant des zones spatiales de dimensions plus petites que la longueur d'onde, un point chaud pouvant être produit à proximité de deux nanoparticules très proches (1 à 4 nm) où le champ électromagnétique est localisé et intense.

La possibilité de produire et de contrôler des points chauds est ainsi en lien avec la réalisation de substrats SERS présentant des nanostructures contrôlées.

La qualité d'un substrat SERS se mesure non seulement à ses performances d'amplification du signal Raman (quantifiées par le facteur d'exaltation EF), mais aussi à sa reproductibilité de fabrication et de réponse, ainsi qu'à sa stabilité au cours du temps.

La recherche de substrats SERS optimisés est extrêmement active, car malgré de grandes avancées dans le domaine, il reste encore de nombreux défis à relever en terme de (i) qualités intrinsèques et (ii) versatilité.

La fabrication de substrats SERS par dépôt de colloïdes puis séchage est une expertise à part entière. En effet, l'exploitation de protocoles abondamment décrits dans la littérature pour la préparation des colloïdes SERS actifs ne garantit aucunement de pouvoir reproduire la taille, les formes des objets. Il y a un besoin indispensable pour les utilisateurs finaux du SERS comme technique analytique, de disposer de substrats prêts à l'emploi, où il suffira de déposer une goutte de la solution à analyser.

La mise au point de substrats SERS efficaces sur une large plage de longueurs d'onde d'excitation fait partie également des challenges du domaine.

Les procédés de synthèse des nanoparticules métalliques connus dans l'art antérieur présentent de nombreux inconvénients, ne permettant pas une utilisation optimale dans la réalisation de substrats pour la spectrométrie Raman exaltée de surface.

Les substrats obtenus par lithographie et gravure sur couches minces sont reproductibles et stables dans le temps, mais leur fabrication est complexe et très couteuse.

Les solutions colloïdales (or, argent), ou les sols-gels sont moins couteux, mais peuvent donner lieu à difficultés, notamment en durée de vie avant utilisation et en reproductibilité. Les colloïdes peuvent floculer puis être remis en suspension, mais aussi précipiter, et agréger de façon irréversible.

La réduction électrochimique implique des conditions contraignantes, telles que l'utilisation des ultrasons et d'un courant d'électrolyse constants, et il est difficile de contrôler l'uniformité des nanoparticules obtenues par ces procédés.

Des nanoparticules d'or de différentes formes ont été synthétisées par voie électrochimique en présence d'agent de surface.

Huang et al (Electrochemical synthesis of gold nanocubes, Materials Letters. July 2006 60 (15):1896-1900*)* décrivent la synthèse de nanoparticules d'or de forme cubique, par électrolyse (anode Au, cathode Pt) d'une solution contenant de l'acétone et deux agents de surface : CTAB (bromure d'hexadécyltriméthylammonium ou bromure de cétrimonium) : (CH₃)₃N(CH₂)₁₅CH₃Br, CAS 57-09-0) et TTAB (bromure de tétradecyltrimethylammonium C₁₇H₃₈BrN, CAS 1119-97-7*)*.

Ma et al (Synthesis of silver and gold nanoparticles by a novel electrochemical method, Chemphyschem. 2004 Jan 23; 5(1):68-75*)* décrivent la synthèse de nanoparticules d'or de forme sphérique par électrolyse d'une solution aqueuse contenant du PVP (Polyvinylpyrrolidone, CAS 9003-39-8*)*.

Sharma et al (Electrochemical synthesis of gold nanorods in track-etched polycarbonate membrane using removable mercury cathode, Journal of Nanoparticle Research. 2012, Vol. 14 Issue 9, p1-10) décrivent la synthèse de nanoparticules d'or en forme de bâtonnets, par dépôt sur une membrane nanoporeuse en polycarbonate.

Yu et al (Gold nanorods : electrochemical synthesis and optical properties, The journal of physical chemistry, 101, 34, pp. 6661-6664*)* décrivent la synthèse de nanoparticules d'or en forme de bâtonnets, par électrolyse (anode Au, cathode Pt) d'une solution contenant de l'acétone, et deux agents de surface (CTAB et TC8AB bromure de tétraoctylamonium CAS 14866-33-2).

Les synthèses par irradiation micro-ondes, radiolyse, photochimie et sonochimie sont complexes et onéreuses, et nécessitent un apport d'énergie important. La radiolyse nécessite l'emploi d'un accélérateur de particules.

Un grand nombre de synthèses par réduction chimique, à l'aide d'un mélange sel métallique /solvant/ réducteur/ surfactant ont été proposées, sans qu'il soit possible de contrôler efficacement la géométrie des nanoparticules obtenues. Dans ces mélanges, le sel est le précurseur contenant le métal, le solvant est polaire, aqueux ou organique (polyol, toluène), le moment dipolaire du solvant étant assez élevé pour rompre les liaisons du sel et le dissoudre, le réducteur réduit les espèces métalliques dissoutes afin qu'elles précipitent, et le surfactant protège les particules en s'adsorbant à leur surface pour éviter leur agglomération.

Dans les synthèses de type Turkevich, permettant de produire des nanoparticules d'or de forme quasi-sphériques et mono-disperses en suspension dans l'eau, d'acide tétrachloraurique est réduit par le citrate, qui joue à la fois le rôle de réducteur et d'agent de surface.

Dans les synthèses de type Brust, l'acide chloraurique réagit avec du bromure de tétraoctylammonium (agent de transfert) dans le toluène (solvant) et le borohydrure de sodium (réducteur).

L'invention se rapporte plus spécifiquement à la synthèse de nanoparticules métalliques, de type cœur-coquille, par une approche de type bottom-up, par voie chimique colloïdale, le cœur se présentant sous forme de bâtonnets.

La production de nanoparticules métalliques, en particulier d'or, sous forme de bâtonnets, est connue en soit. On peut se reporter par exemple au mécanisme de croissance dénommé zipping, décrit dans le document Hébié Etudes électrochimiques des nanoparticules d'or corrélation structure/activité, 2013*.*

L'invention vise en particulier à fournir des nanoparticules métalliques or/argent, de type cœur-coquille, par une approche de type bottom-up, par voie chimique colloïdale, le cœur se présentant sous forme de bâtonnets, en particulier de bâtonnets d'or, la coquille en argent étant monocristalline.

Des exemples de synthèses de nanoparticules cœur-coquille or-argent sont présentés dans les documents suivants :
Bai et al, Acs Applied Materials & Interfaces 2014, 6 (5), 3331-3340 *;*
Cho et al Advanced Materials 2010, 22 (6), 744 *;*
Zhang et al Chemistry of Materials 2016, 28 (8), 2728-2741 *;*
Jing, H et al Nano Letters 2014, 14 (6), 3674-3682 *;*
Pastoriza-Santos, Langmuir 2002, 18 (7), 2888-2894 *;*
Zhuo et al Acs Nano 2015, 9 (7), 7523-7535 *;*
Liu et al Physical Chemistry Chemical Physics 2015, 17 (10), 6819-6826 *;* Yang et al Journal of the American Chemical Society 2014, 136 (23), 8153-8156 *;*
Yang et al Chemistry European Journal 2015, 21 (3), 988-992 *;*
Zhang et al Chemistry European Journal 2013, 19 (38), 12732-12738*.*

Khlebtsov et al (Au@Ag core/shell cuboids and dumbbells: Optical properties and SERS response, Journal of Quantitative Spectroscopy and Radiative Transfer, Volume 167, 2015, Pages 64-75*)* décrivent la synthèse de nanoparticules cœur-coquille or/argent, pour la réalisation de substrats SERS, des bâtonnets d'or placés dans une solution de CTAC (chlorure d'hexadécyltriméthylammonium CH₃(CH₂)₁₅N(Cl)(CH₃)₃, CAS 112-02-7), formant le cœur, le dépôt de la coquille d'argent étant obtenu par addition de nitrate d'argent, d'acide ascorbique et de soude.

Le document WO 2016/046645 décrit la synthèse de nanoparticules d'or asymétriques, par réaction de bâtonnets d'or en présence d'un solvant tel que de l'eau, d'un précurseur (HAuCl₄), d'un ligand tel qu'un thiol (4-mercaptophenol) et d'un agent réducteur (acide ascorbique), une concentration élevée de ligand inhibant la croissance de l'or par épitaxie sur les bâtonnets, et favorisant une croissance asymétrique. Les applications mentionnées sont la captation de l'énergie solaire et la réalisation de substrats pour le SERS.

### Objets de l'invention

Un premier objet de l'invention est de résoudre les problèmes présentés ci-dessus, en offrant une voie de synthèse originale de nanoparticules métalliques cœur-coquille, en particulier or/argent, cette synthèse étant économique, et permettant la production d'une grande variété de formes de nanoparticules, de manière contrôlée.

Un autre objet de l'invention est de fournir une solution colloïdale de nanoparticules métalliques, adaptée à la production de substrats pour la spectroscopie Raman exaltée de surface SERS.

Un autre objet de l'invention est de fournir un capteur SERS, notamment pour un polluant tel que l'atrazine.

### Présentation générale de l'invention

A ces fins, il est proposé, selon un premier aspect, un procédé de synthèse de nanoparticules cœur-coquille or-argent, à partir d'une solution aqueuse colloïdale de germes d'or avec tensioactif, les nanoparticules cœur-coquille or-argent étant réalisées à partir de germes d'or anisotropes, ce procédé comprenant l'ajout dans la solution aqueuse colloïdale d'un précurseur d'argent et un réducteur, pour réaliser le dépôt d'argent sur les germes d'or dans une étape dite principale, le procédé présentant une étape d'incubation de la solution aqueuse colloïdale contenant les germes d'or avec tensioactif dans un mélange eau+ DMSO, avant l'étape principale réalisée avec la solution aqueuse colloïdale d'or résultante (germes d'or+eau+DMSO+tensioactif).

Il est ainsi proposé un procédé de synthèse de nanoparticules cœur-coquille or-argent, à partir d'une solution aqueuse colloïdale de germes d'or avec tensioactif, selon la revendication 1.

Dans certaines mises en œuvre, la troisième durée va de quelques minutes à une vingtaine d'heures.

Le DMSO (diméthylsulfoxyde, CAS 67-68-5) est un solvant aprotique dipolaire. Ce type de solvant présente des charges par effet mésomère et se coordine sur une maille CFC (111) de l'or. Par conséquent, cette couche pourra empoisonner la surface de l'or, inhibant ainsi la croissance de l'argent. Les pointes des nano bâtonnets, essentiellement constituées par des facettes (111) peuvent être coordinées par le co-solvant, perturbant ainsi significativement la diffusion vers la surface et le dépôt d'argent sur ces facettes

Un solvant aprotique n'a pas d'atome d'hydrogène acide. Un solvant aprotique dipolaire ne peut former de liaison hydrogène, et leurs molécules agissent comme des dipôles.

Les solvants aprotique dipolaire sont par exemple le DMSO (diméthylsulfoxyde, CAS 67-68-5), le DMF (Diméthylformamide CAS 68-12-2), l'acétonitrile (CH₃CN, CAS 75-05-8), le NMP (N-méthyl-2-pyrrolidone, CAS 872-50-4).

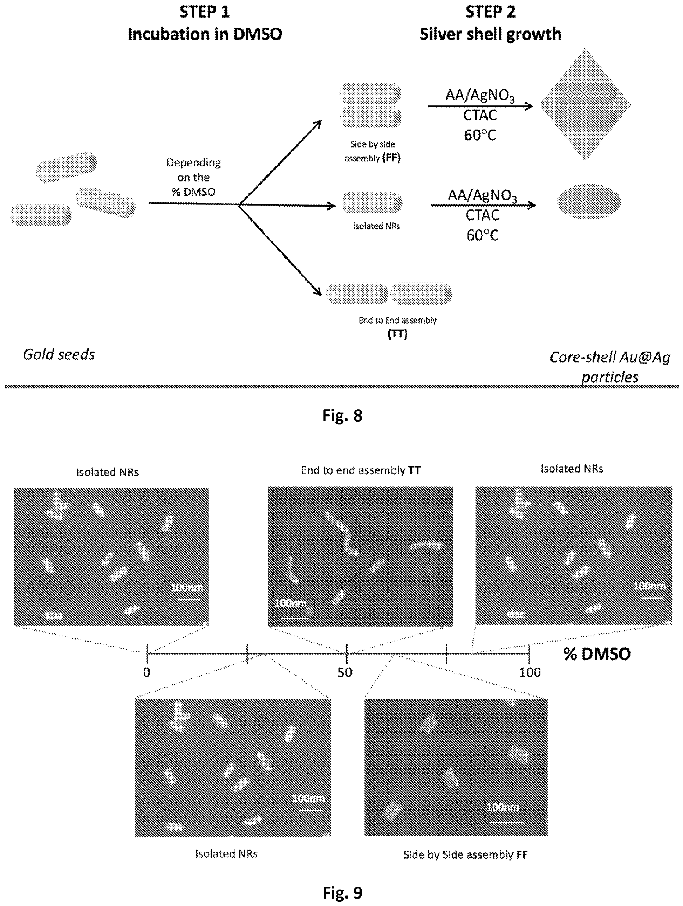

Selon diverses mises en oeuvre, le procédé présente les caractères suivants, le cas échéant combinés :
- le ratio entre le volume de DMSO et le volume total d'eau est inférieur à 2 ; on entend par volume total de l'eau le volume apporté par la solution aqueuse colloïdale contenant les germes d'or avec tensioactif et par l'eau présente dans le mélange eau+DMSO ;
- le ratio entre le volume de DMSO et le volume total d'eau est inférieur ou égal à 0.33 ; avantageusement le ratio est autour de ou égal à 0,33, ce qui permet d'avoir essentiellement des germes d'or bien dispersés et d'incorporer un seul germe d'or dans une coquille d'argent ;
- le ratio entre le volume de DMSO et le volume total d'eau est compris entre 0.33 et 1 ; avantageusement le ratio est autour de ou égal à 1, ce qui permet d'avoir essentiellement des assemblages des germes d'or pointe contre pointe (tête contre tête) enveloppés ensuite par une coquille d'argent ;
- le ratio entre le volume de DMSO et le volume total d'eau est compris entre 1 et 1.5 ; avantageusement le ratio est autour de ou égal à 1,5, ce qui permet d'incorporer des germes d'or face contre face FF dans une coquille d'argent ;
- le ratio entre le volume de DMSO et le volume total d'eau est supérieur à 1.5 ; ce qui permet à nouveau d'avoir essentiellement des germes d'or bien dispersés et d'incorporer un seul germe d'or par coquille d'argent, comme représenté sur la figure 9 ;
- le procédé comprend successivement
   ∘ l'étape d'incubation de la solution aqueuse colloïdale contenant les germes d'or avec tensioactif dans le DMSO, pendant une première durée donnée ;
   ∘ une étape d'ajout d'un autre tensioactif ;
   ∘ une étape de chauffage, pendant une deuxième durée donnée ;
   ∘ l'étape principale de réaction des germes d'or avec le précurseur d'argent et le réducteur dans la solution aqueuse colloïdale de germes d'or ;
   ∘ après une troisième durée donnée, une étape de centrifugation du mélange ;
- l'étape de réaction comprend l'ajout de tensioactif avec le réducteur ;
- le tensioactif peut être du chlorure de cetyltrimethylammonium (CTAC) et/ou de bromure de cetyltriméthylammonium (CTAB) ;
- le réducteur est l'acide ascorbique (AA) ;
- le précurseur d'argent est du nitrate d'argent.

Il est proposé, selon un deuxième aspect, des nanoparticules cœur-coquille or-argent réalisées à partir de germes d'or de forme allongée, obtenu par le procédé tel que présenté ci-dessus, les nanoparticules cœur-coquille or-argent présentant au moins deux germes d'or par cœur pour une coquille d'argent enveloppant le cœur.

Dans une mise en œuvre, les germes d'or sont disposés tête contre tête (TT) dans la coquille d'argent.

Dans une autre mise en œuvre, les germes d'or sont disposés face contre face (FF) dans la coquille d'argent.

Avantageusement, les germes d'or sont des nano bâtonnets.

Il est proposé, selon un autre aspect, une solution colloïdale comprenant des nanoparticules cœur-coquille or-argent telles que présentées ci-dessus.

Il est proposé, selon un autre aspect, un substrat pour spectroscopie Raman exaltée de surface (SERS) comprenant des nanoparticules cœur-coquille or-argent telles que présentées ci-dessus.

Avantageusement, un tel substrat est appliqué à la détection de polluants organiques.

Dans une mise en œuvre, le polluant organique est l'atrazine (CAS 217-617-8).

### Liste des figures

D'autres objets et avantages de l'invention apparaîtront à la lumière de la description d'un mode de réalisation, faite ci-après en référence aux dessins annexés dans lesquels :
- la figure 1 est une vue en microscopie électronique à balayage de nanoparticules d'or, en forme de nano bâtonnets de différents rapports d'aspect (rapport de la plus grande dimension sur la plus petite dimension);
- les figure 2-A et 2-B présentent une vue en microscopie électronique à balayage de nanoparticules cœur-coquille or/argent, selon une mise en oeuvre du procédé selon l'invention ;
- la figure 3 est une vue en microscopie électronique à balayage de nanoparticules cœur-coquille or/argent résultant de la surcroissance d'argent sur des nanoparticules cœur-coquille or/argent, selon une autre mise en œuvre du procédé selon l'invention ;
- la figure 4 est un spectre d'absorption des solutions de nanoparticules d'or pour différents ajouts de DMSO ;
- la figure 5-A est un graphe représentant l'évolution du spectre d'absorption des solutions colloïdales au cours du temps après addition de nitrate d'argent et d'acide ascorbique ; la figure 5-B est un graphe représentant l'évolution de la longueur d'onde du maximum de la résonance longitudinale en fonction du temps, suite à l'ajout de nitrate d'argent et d'acide ascorbique dans des solutions contenant des nanoparticules d'or, avec emploi de différents co-solvants (MeCN, DMSO, EtOH), ou sans l'emploi de co-solvant ;
- les figures 6 et 7 sont des vues en microscopie électronique à balayage d'arrangements de nanoparticules obtenues selon un procédé de synthèse selon l'invention ;
- la figure 8 est une représentation schématique du procédé de synthèse selon les proportions de DMSO dans le milieu réactionnel et les particules cœur-coquille résultantes ;
- la figure 9 est une représentation schématique de l'effet du DMSO sur les propriétés des nano particules d'or, avec ici DMSO = (volume de DMSO)/(Volume total) avec Volume total=Volume en eau + Volume en DMSO.

### Description détaillée de modes de réalisation

Dans une première étape, une synthèse de nano bâtonnets d'or est effectuée, selon une méthode conventionnelle.

Ainsi qu'il a été indiqué, la synthèse de nano bâtonnets d'or, en solution colloïdale, est connue en soit, et n'est pas décrite à nouveau ici.

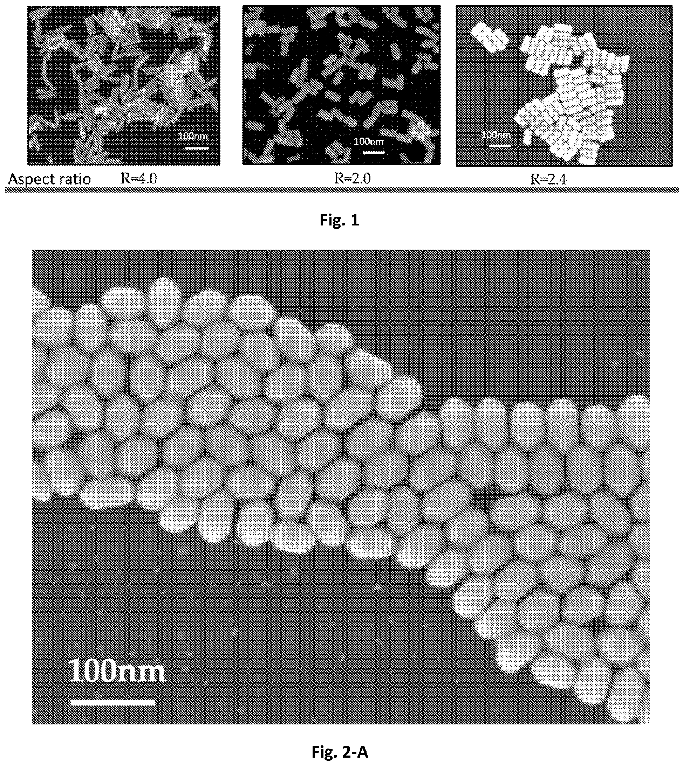

Les nano bâtonnets d'or sont de forme générale représentée en figure 1. A titre indicatif, trois familles de nano-bâtonnets exploitées dans les synthèses sont présentées de gauche à droite sur la Figure 1 pour des rapports d'aspect de 4.0 (55x14 nm), 2.0 (76x37 nm) et 2.4 (96x40 nm). Les grandeurs entre parenthèses exprimées en nanomètres représentent, dans l'ordre, la longueur moyenne selon le grand axe du bâtonnet et selon le petit axe.

Les nano bâtonnets d'or sont incubés dans un solvant aprotique dipolaire.

Dans une mise en oeuvre, ce solvant est du dimethyl sulfoxide DMSO.

A titre d'exemple, les nano bâtonnets d'or (120 µl à 1.82nM) sont incubés dans 100µl de dimethyl sulfoxide DMSO pendant 30 min.

Puis, les nano bâtonnets d'or sont transférés dans une solution de CTAC (chlorure de cetyltrimethylammonium) et chauffés.

A titre d'exemple, les nano bâtonnets sont transférés dans une solution de CTAC (26mg dans 3,8mL d'eau) et chauffé à 60°C pendant 20min.

Le dépôt d'argent est amorcé, par ajout à la préparation précédente, d'une solution de nitrate d'argent AgNO₃, et d'une solution contenant de l'acide ascorbique AA et du CTAC.

A titre d'exemple, le dépôt d'argent est amorcé par ajout d'une solution de nitrate d'argent AgNO₃ (2mM, 1.2mL), et d'une solution contenant de l'acide ascorbique (AA, 45mM, 1.2mL) et du CTAC (40mM).

Un protocole complet de préparation **P** est le suivant, dans un mode de réalisation.

Dans un tube contenant 300µl de nano bâtonnets d'or (C= 0.15nM), sont introduits 100µL de DMSO, et la solution est laissée au repos pendant 5 minutes, puis additionnée à une solution aqueuse de CTAC (26mg de CTAC dans 4.6mL d'eau Milli-Q) préalablement chauffée à 60°C. La solution résultante est agitée dans un bain marie à 60°C pendant 20min. L'étape de dépôt est amorcée par l'ajout de 1.2mL d'une solution de AgNO₃ à 2mM et 1.2mL d'une solution AA (44mM)/CTAC (40mM) à l'abri de la lumière. L'ajout se fait en goutte à goutte sous agitation modérée. Le dépôt d'argent est arrêté après 100min, en centrifugeant à 6000 rpm pendant 8min.

Un autre protocole de préparation permet de travailler à plus grande échelle, comme premier pas vers une industrialisation du procédé de synthèse. Ce procédé permettant en une mise en oeuvre de produire jusqu'à 1000 fois plus de particules cœur-coquille or-argent, est le suivant :
Dans 16 tubes contenant chacun 150µL de nano bâtonnets d'or (C= 17nM), sont introduits 1.15mL de DMSO, et la solution est laissée au repos pendant 10 minutes. Le contenant des 16 tubes est ajouté à une solution aqueuse de CTAC (320 mg de CATC dans 22mL d'eau) préalablement chauffée à 60°C. La solution résultante est maintenue à 60°C et sous agitation pendant 20min. L'étape de dépôt est amorcée par l'ajout de 10mL d'une solution de AgNO₃ à 4mM et 10mL d'une solution AA (100mM)/CTAC (80mM) à l'abri de la lumière. L'ajout se fait en goutte à goutte sous agitation modérée. Le dépôt d'argent est arrêté après une durée comprise entre 90 min et 20 heures (selon la forme de particule souhaitée), en centrifugeant à 6000 rpm pendant 5min.

La forme de l'objet final et l'épaisseur d'argent déposé sont modulés par la proportion de DMSO dans le mélange, la quantité de précurseur d'argent et le temps de réaction avant centrifugation du mélange.

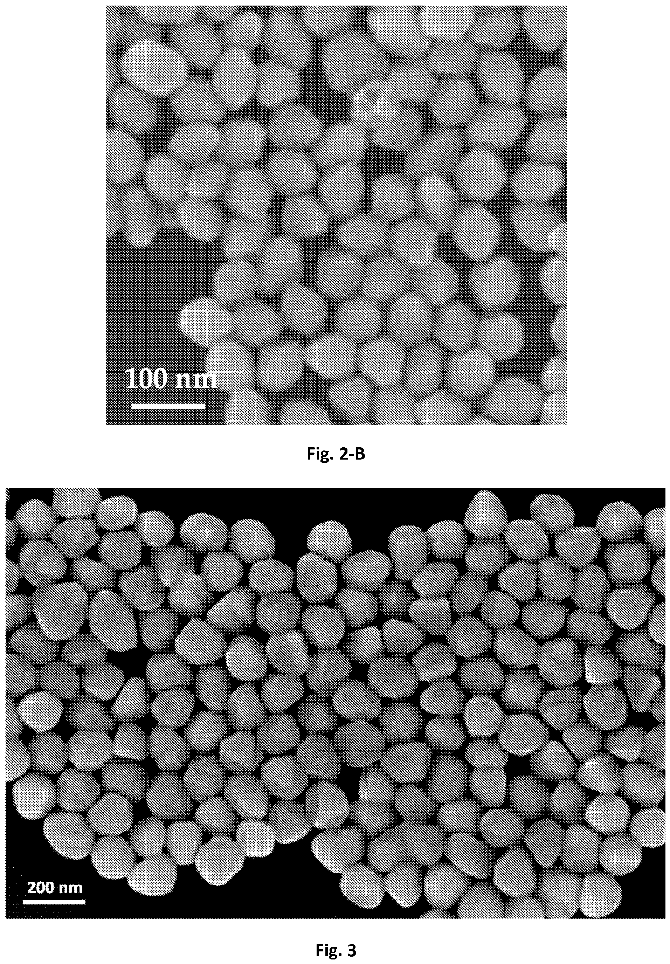

La forme des nano particules cœur-coquille or/argent est celle d'une ogive, ainsi qu'il apparait en figure 2.

Le dépôt d'argent se fait essentiellement selon le petit axe et les pointes des bâtonnets d'or affleurent à la surface des cœur-coquilles. Ces dépôts anisotropes dans les deux directions engendrent une diminution du rapport d'aspect, qui est de 1.4 pour les nanoparticules cœur-coquille, à comparer au rapport de 3.9 pour les nano bâtonnets d'or de départ.

Le dépôt d'argent sur l'or est suivi par spectroscopie d'extinction UV-visible, avec un décalage progressif de la résonance plasmon longitudinale vers le bleu.

Les propriétés optiques des nanoparticules cœur-coquille obtenus, la position de la bande d'extinction correspondant à la résonance de plasmon longitudinale des nanoparticules est modulable entre 510 et 800 nm, selon l'épaisseur du dépôt d'argent et le rapport d'aspect du germe d'or de départ.

Tirant parti de la résonance de plasmon de surface localisée des nanoparticules or/argent synthétisées et de la meilleure exaltation attendue pour l'argent (comparée à l'or seul), des caractérisations en spectroscopie Raman exaltée de surface (SERS) ont été menées en solution en présence de sondes moléculaires.

Les spectres montrent une exaltation du signal Raman entre 4 et 100 fois, par rapport à celui enregistré pour des nanoparticules cœur-coquilles or/argent obtenues dans l'eau sans co-solvant.

Par cette synthèse, les nanoparticules cœur-coquilles or/argent obtenues par le procédé selon l'invention, contiennent des traces de DMSO visibles par spectroscopie.

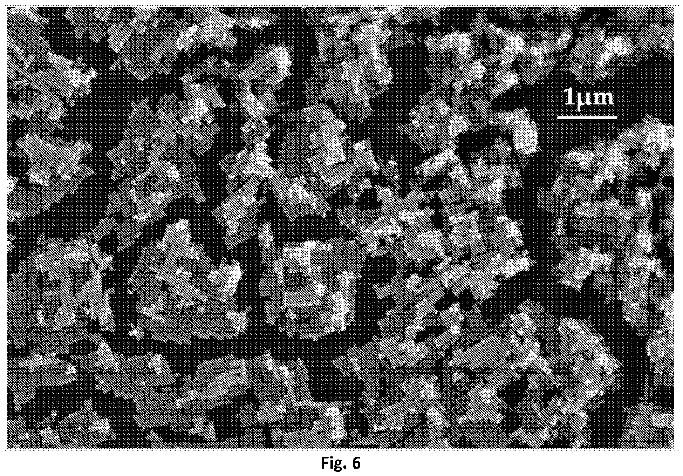

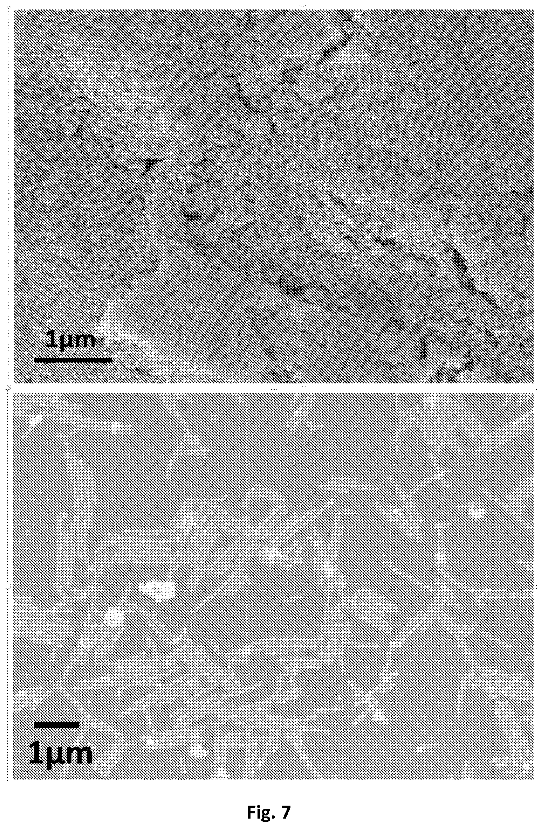

Une fois isolés et déposés sur support solide (lame de silicium par exemple), les cœur-coquilles obtenus s'auto-organisent spontanément en réseau 3D, structure 2D ou en chaine 1D, de longueurs (ou surfaces) supérieures à 1 micromètre, selon la concentration de la solution déposée et la forme des nanoparticules cœur-coquille. Les figures 6 et 7 montrent quelques exemples d'arrangement obtenus.

Comme illustré sur les figures 6 et 7, les réseaux de nanoparticules (NP) cœur-coquille or/argent organisés en 1D, 2D ou 3D présentent un ordre à longue distance allant de quelques microns à quelques dizaines de microns. Pour les arrangements en 2D et 3D, ils peuvent présenter des surfaces d'au moins 10 micromètres carrés, avantageusement de 40 micromètres carrés, voire plus grandes, et qui sont répétées sur le substrat. Ces grandes surfaces obtenues peuvent s'expliquer notamment par le fait de la grande homogénéité de forme des NP obtenues par le procédé.

Comme illustré sur la structure 3D de la figure 6, des NP présentent des couleurs blanches, un peu grisées ou plus grisées, en fonction de leur distance au microscope.

Ces réseaux sont obtenus en particulier avec les nanoparticules cœur-coquille or/argent ayant un seul germe d'or entouré par une coquille d'argent.

En fonction notamment des concentrations utilisées de tensioactifs, de nanoparticules cœur-coquille or-argent, d'épaisseur de la couche d'argent, de la taille des germes d'or, il est obtenu plutôt certains arrangements. Par exemple, des germes d'or enrobés par un faible dépôt d'argent (moins de 5 nm) donnent plutôt des chaines 1D, alors que des particules cœur-coquille or/argent avec une couche d'argent plus épaisse (10 nm et plus) s'organisent plutôt en réseaux 2D ou 3D. Par ailleurs, ces domaines ordonnés seront distants sur le substrat de silicium si le dépôt se fait à partir de solutions diluées de nanoparticules cœur-coquille or-argent dans l'eau.

### Influence de la quantité de co-solvant

Des essais ont été conduits, en
- maintenant le type du germe d'or de départ et sa quantité, la quantité du réducteur et du précurseur d'argent, le temps de la réaction avant centrifugation ;
- variant le rapport DMSO/H₂O

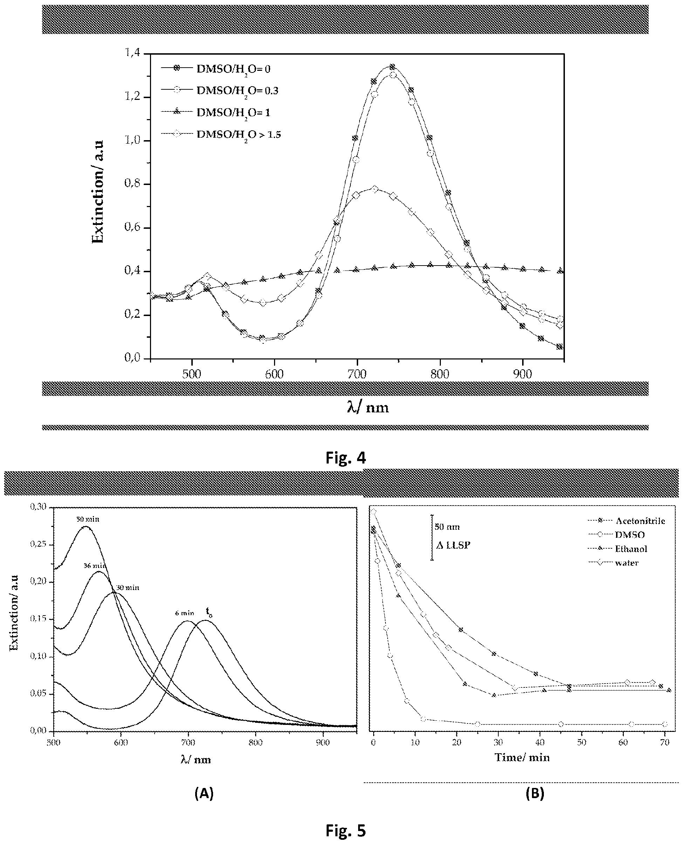

Selon la proportion de DMSO rajouté dans le milieu, trois comportements limites ont été identifiés en solution, par spectroscopie d'absorption, comme illustré en figure 4.

Pour des ratios DMSO/H₂O inférieurs à 0,33 (ici ratio en volume =Volume DMSO/volume total d'eau), la stabilité des nano-bâtonnets d'or est maintenue en solution et ces derniers restent à distance les uns des autres.

Pour un ratio de DMSO/H₂O de 1 dans la solution de départ, un assemblage en solution pointe contre pointe des nano-bâtonnets d'or est mis en évidence (figure 9). Cet assemblage est décelé par l'apparition aux temps courts d'une bande, décalée vers le rouge par rapport à la bande de résonance plasmon longitudinale des nano-bâtonnets de départ. Par assemblage pointe contre pointe (ou tête contre tête TT), on désigne ici l'observation du rapprochement des nano-bâtonnets par leurs parties extrêmes, les nano-bâtonnets contigus étant alignés entre eux ou formant un angle entre eux.

Enfin, pour un ratio plus important de DMSO/H₂O (1.5) dans la solution de départ, le suivi cinétique par spectroscopie d'absorption au cours du temps, montre un décalage croissant vers le bleu de la résonance longitudinale et un décalage croissant vers le rouge de la résonance transverse. Ces modifications spectrales sont caractéristiques d'un assemblage face contre face (FF) des nanoparticules (figure 9). Par assemblage face contre face, on désigne ici l'observation du rapprochement des nano-bâtonnets par leurs faces latérales, les directions d'élancement des nano-bâtonnets contigus étant sensiblement parallèles.

La figure 9 illustre les différents états des nano bâtonnets d'or, en fonction du pourcentage de DMSO (proportion de DMSO dans le mélange eau + DMSO).

A une valeur de 50% de DMSO, les nano bâtonnets d'or sont assemblés en solution pointe contre pointe.

A une valeur de 60% de DMSO, les nano bâtonnets d'or apparaissent assemblés en solution en paire face contre face.

A une valeur de 25% (ou inférieure à 25%) de DMSO, les nano bâtonnets d'or apparaissent dispersés en solution. Pour des proportions de DMSO comprises entre ces valeurs caractéristiques, les nano bâtonnets d'or se présentent sous la forme de populations de deux types, par exemple assemblées face contre face et pointe contre pointe, pour des proportions de DMSO comprises entre 50 et 60%.

Pour des pourcentages en DMSO dans le mélange compris entre 80 et 95%, les nano bâtonnets d'or apparaissent à nouveau dispersés en solution et les nanoparticules réalisées par la suite présentent un seul germe d'or par coquille d'argent.

Ainsi, l'utilisation d'un mélange eau-DMSO comme décrit dans l'invention permet :
- d'orienter sélectivement la croissance de l'argent sur la surface d'or, et/ou
- d'assembler les germes d'or en solution face-contre-face (FF) ou tête-contre-tête (TT), ou de les laisser isolés les uns des autres, avant de faire croitre la couche d'argent tout autour.

Les particules après incubation dans le mélange eau-DMSO conservent leur couche de tensioactifs sans laquelle les particules précipiteraient de façon irréversible, rendant le mélange inexploitable. L'ajout de DMSO joue deux rôles. Le DMSO permet d'une part de modifier l'organisation du tensioactif (en jouant sur le potentiel zeta de la suspension colloïdale) à la surface des germes d'or, et d'autre part, est adsorbé sur certaines facettes des germes d'or comme révélé par les études par SERS. Les tensioactifs (CTAB, CTAC) sont toujours présents à la surface des germes, mais adoptent une organisation différente en présence du DMSO.

L'origine des phénomènes observés n'est pas complètement élucidée, les hypothèses suivantes étant avancées.

Le DMSO est un solvant aprotique dipolaire, à caractère fortement dissociant et capable de solubiliser des composés polarisables, polaires et ioniques.

Ce type de solvant présente des charges par effet mésomère et se coordine sur une face particulière (111) du monocristal d'or (CFC) de l'or, par interaction ionique entre son oxygène chargé négativement et un ou deux ad-atomes d'or chargés positivement. Par conséquent, cette couche pourra empoisonner la surface de l'or, inhibant ainsi la croissance de l'argent. Les pointes des nano bâtonnets, essentiellement constituées par des facettes (111) peuvent être coordinées par le DMSO, perturbant ainsi significativement la diffusion vers la surface et le dépôt d'argent sur ces facettes. La coordination du DMSO sur l'or interviendrait via les deux modes de coordination possibles pour ce ligand (S-donneur ou O-donneur).

### Comparaison des effets de différents co-solvants

Des essais ont été effectués afin de comparer les effets du DMSO à celui d'autres co-solvants :
- acétonitrile (MeCN, CAS 75-05-8), solvant polaire aprotique ;
- éthanol (EtOH, CAS 64-17-5), solvant polaire protique ;
- tétrahydrofurane (THF, CAS 109-99-9), solvant polaire aprotique.

Le protocole **P** présenté auparavant a été appliqué, en remplaçant le DMSO par de l'éthanol, ou en remplaçant le volume de DMSO par 75µl de MeCN et 25µl de l'eau Milli-Q, ou en remplaçant le volume de DMSO par de l'eau Milli-Q.

Différents dépôts d'argent ont été réalisés sur des germes d'or pré-incubés dans un mélange eau/co-solvant (identifiés par la suite comme étant NRsEtOH, NRsMeCN et NRsDMSO respectivement pour un mélange avec l'EtOH, le MeCN et le DMSO).

Ces dépôts ont été comparés au même dépôt d'argent sur des nanobâtonnets d'or incubés dans l'eau seulement.

Le suivi cinétique des milieux réactionnels a été réalisé par spectroscopie d'absorption UV-Visible, comme présenté en Figure 5-A.

Les variations de la longueur d'onde du maximum de la bande de résonance longitudinale (ΔLLSP) en fonction du temps montrent un décalage vers le bleu de cette bande, corrélé à un dépôt d'argent selon le petit axe du bâtonnet.

Après 45 min, le décalage de la LLSP le plus important est enregistré pour des nano bâtonnets d'or incubés dans du DMSO ((ΔLLSP) DMSO= 227nm, (ΔLLSP) H2O, MeCN=197nm, (ΔLLSP) EtOH= 183nm) ; comme représenté en figure 5-B.

La vitesse de dépôt d'argent sur ces NRsDMSO est plus rapide que celle du dépôt de l'argent sur des NRsMeCN, des NRsEtOH et des NRsH₂O (utilisés comme référence).

La perturbation de la couche de tensioactif, par ajout de solvant organique tel que l'éthanol ou l'acétonitrile, n'affecte pas directement la forme des cœur-coquilles finaux. Les modifications sont restreintes à de légères différences au niveau de la cinétique de dépôt de l'argent sur l'or et de la longueur d'onde de la résonance longitudinale des objets, attribuées à la différence de solubilité du tensioactif présent sur la surface de l'or dans l'eau, l'éthanol et l'acétonitrile.

En revanche, pour le DMSO, le suivi cinétique montre un déplacement vers le bleu des résonances longitudinale et transverse, et des résonances plus étroites et plus intenses. Ces modifications spectrales peuvent être dues à un dépôt d'argent plus important ou à des différences morphologiques des objets obtenus.

### Essais de surcroissance d'argent sur des cœur-coquille or/argent pour donner des formes particulières aux nanoparticules

Des essais de surcroissance d'argent sur les cœur-coquilles incubés dans du DMSO ont été réalisés. Un décalage vers le bleu de la longueur d'onde de la résonance longitudinale des objets de départ est constaté. Les images MEB montrent que le dépôt se fait essentiellement selon le petit axe et dans un seul sens, et les objets finaux ressemblent à des pyramides dont la base est un nano bâtonnet d'or, comme illustré en figure 3.

### Dépôt d'argent sur des dimères

Nous avons mis en évidence le rôle du DMSO dans l'assemblage des nano bâtonnets d'or en dimères face contre face FF pour un ratio eau/DMSO bien spécifique, ainsi que son effet sur la forme finale des particules cœur-coquille. Ainsi, l'ajout du DMSO dans la solution colloïdale de telle sorte que le ratio DMSO/H₂O soit égal à 1.5, engendre cet assemblage FF des nano bâtonnets d'or de départ.

A noter que l'ajout de tensioactif pendant l'étape d'incubation permet d'arrêter l'assemblage des germes d'or soit tête contre tête (TT) soit face contre face (FF) (en fonction du ratio volume DMSO sur volume eau). Ainsi, en fonction du moment choisi pour cet ajout, il peut être réalisé des assemblages à deux, trois, quatre etc...germes d'or pour le cœur enveloppés ensuite par la coquille d'argent.

Cet assemblage est mis en évidence par un décalage croissant vers le bleu de la résonance longitudinale et un décalage croissant vers le rouge de la résonance transverse.

L'assemblage des NRs Au en configuration FF est probablement dû aux forces de déplétion (attractives), qui déstabilisent la solution colloïdale. C'est le pouvoir solubilisant du DMSO qui est mis en jeu dans ce phénomène de désorption partielle du tensioactif de la bicouche de surfactant autour des particules.

La diminution de la répulsion électrostatique entre les bâtonnets, en plus des interactions attractives de Van der Waals entre les chaines hydrophobes ainsi exposées sera la force motrice de l'assemblage en dimère dans un premier temps, puis en oligomères aux temps longs.

Pour figer le système à l'état du dimère et éviter la formation d'oligomères, la concentration en surfactant CTAC dans le milieu est brutalement augmentée au-delà de la CMC_{CTAC}.

En effet, l'ajout de CTAC en excès reforme la bicouche du CTAC avec les chaines hydrophobes exposées autour des dimères et évite toute agrégation par répulsion électrostatique.

L'encapsulation des dimères FF dans une couche d'argent a été réalisée par réduction du précurseur AgNO₃ avec l'acide ascorbique AA dans la solution de dimères à 60°C.

Un protocole de fabrication de nanoparticules dimères cœur-coquille est le suivant, dans une mise en oeuvre : à 100µL d'une solution de nano bâtonnets d'or NRsAu (4nM), un volume de 150µL de DMSO est ajouté et l'assemblage face contre face des nano bâtonnets d'or est arrêté en rajoutant 800µL de CTAC 8mM. La solution est centrifugée et redispersée dans 5mL de CTAC 16mM. Pour déclencher le dépôt, 1.2mL de la solution aqueuse de AgNO₃ à 2mM et 1.2mL de la solution aqueuse AA (44mM)/CTAC (40mM) est ajoutée, à l'abri de la lumière. L'ajout se fait en goutte à goutte sous agitation modérée. Le dépôt est arrêté après 60min en centrifugeant à 6000rpm pendant 8min.

Le dépôt d'argent est révélé lors du suivi par spectroscopie d'absorption, par un décalage d'au moins 100nm vers le bleu de la résonance LLSP après seulement 3 minutes de réaction.

Les particules cœur-coquille obtenues se présentent sous la forme d'octaèdres, avec des pointes plus prononcées, ce qui leurs confèrent des propriétés d'exaltation plus intéressantes, comme représenté en figure 3.

### Applications

Les études comparées par SERS de particules obtenues par cette nouvelle voie de synthèse, montrent une augmentation du gain SERS, par rapport aux particules cuboïdes classiquement obtenues dans l'eau. Les substrats SERS de l'invention présentent une plus grande homogénéité en termes de réponse par rapport à ceux de l'état de l'art, du fait de la plus grande homogénéité d'agencement des nanoparticules cœur -coquille or-argent déposées.

Les nanoparticules cœur-coquille or-argent obtenues (NRsAu@Ag) présentant des extrémités plus pointues induiront un plus fort confinement du champ aux pointes.

### Application à la détection de l'atrazine (ATR)

À 183µl d'eau Milli-Q basique (pH égale à 6 ajusté par l'addition de NaOH 0.1M), un volume x d'ATR (1, 0.1, 0.01, 0.001mM dans l'acétonitrile) et y de β-CD ou β- cyclodextrine (6, 0.66, 0.066, 0.0066 mM dans l'eau) sont ajoutés. Les solutions préparées au préalable sont ajoutées à 100µl de NRsAu@Ag. Les valeurs de x et y (compris entre 4 et 16µl) ainsi que les concentrations de la β-CD et de l'ATR sont choisies de telles sortes que les concentrations finales en ATR et en β-CD soient égales à 0.05, 1, 3, 6, 12.5, 25, 100, 200µM. Les solutions sont incubées pendant 1 heure avant de les caractériser par SERS. L'alpha-cyclodextrine peut aussi être utilisée pour détecter l'atrazine.

### Avantages de l'invention

L'invention présente de nombreux avantages.

L'invention permet la modulation des formes et de l'auto-assemblage de nanoparticules cœur-coquille or-argent, par une voie de synthèse originale en milieu eau/co-solvant organique.

Ce procédé de synthèse permet d'inclure un ou plusieurs germes d'or de forme allongée (nano bâtonnet de dimension allant de 15 à 150 nm), dans une matrice d'argent monocristalline.

Il est possible d'incorporer plus d'un germe nano-bâtonnet d'or. En effet, les proportions relatives eau/DMSO induisent, pour certaines compositions, un assemblage des nano bâtonnets d'or face contre face, lors de l'étape d'incubation.

Ce procédé est remarquablement plus simple que ceux communément utilisés dans la littérature, pour obtenir des formes plus exotiques que les cuboïdes classiques.

Lors de la surcroissance de l'argent sur l'or, la forme des particules cœur-coquilles est contrôlée, par la cinétique de dépôt des atomes d'argent sur la surface d'or.

L'invention présente plusieurs avantages, pour la fabrication de substrats SERS.

L'approche bottom-up de préparation permet de moduler la taille, la forme et donc la position de la résonance plasmon du substrat, permettant d'envisager plusieurs longueurs d'onde d'excitation laser (532, 632.8 et 785 nm).

De plus, la coquille des nanoparticules en argent est un atout en termes de facteur d'exaltation, puisque l'argent est connu pour être plus efficace que l'or (interbande responsable des pertes par amortissement du plasmon situé dans le visible pour l'or et dans l'UV pour l'argent).

De plus, l'auto-assemblage sur substrat solide des nanoparticules obtenues par le procédé de synthèse, ouvre vers des applications capteurs SERS.

Une approche bottom-up de fabrication de ces substrats SERS à partir de colloïdes constitue une alternative aux approches top-down par lithographie physique, qui bien que coûteuses demeurent actuellement privilégiées pour les substrats commerciaux (meilleure reproductibilité). L'un des inconvénients des colloïdes, par rapport aux substrats lithographiques, est le caractère plus aléatoire et non reproductible de l'emplacement des points chauds. Les mécanismes d'auto-assemblage des nanoparticules permettent une plus grande constance des propriétés des substrats.

Les arrangements spontanés sur surface des nanoparticules cœur-coquilles permettent d'élaborer de nouveaux substrats SERS, pour des applications capteurs, par exemple pour les applications suivantes :
- agroalimentaire: par exemple pour la détection de mélamine dans le lait ;
- police scientifique/ sécurité: drogue, poison, explosifs ;
- analyse environnementale des contaminants dans l'eau: PCB, atrazine, pesticide, hormones ;
- biocapteurs (diagnostic précoce de marqueurs).

Les applications envisagées se placent dans le domaine des capteurs chimiques utilisant la spectroscopie Raman exaltée de surface, comme outil pour quantifier et identifier l'analyte d'intérêt.

## Revendications

1. Procédé de synthèse de nanoparticules cœur-coquille or-argent, à partir d'une solution aqueuse colloïdale de germes d'or avec tensioactif, les nanoparticules cœur-coquille or-argent étant réalisées à partir de germes d'or anisotropes, **caractérisé en ce que** le procédé comprend successivement :
- une étape d'incubation de la solution aqueuse colloïdale contenant les germes d'or avec tensioactif, dans un mélange de solvants eau et DMSO, pendant une première durée donnée; pour modifier l'organisation du tensioactif et l'assemblage des germes d'or;
- une étape d'ajout d'un tensioactif dans le mélange résultant précédent;
- une étape de chauffage, du mélange résultant pendant une deuxième durée donnée ;
- une étape d'ajout dans le mélange résultant d'un précurseur d'argent et d'un réducteur, pour réaliser le dépôt d'argent sur les germes d'or, dans une étape dite principale, pendant une troisième durée donnée ;
- une étape d'extraction des nanoparticules.

2. Procédé selon la revendication 1, **caractérisé en ce que** le ratio entre le volume de DMSO et le volume total d'eau est inférieur à 2 et supérieur à 0.1. le volume total de l'eau étant le volume apporté par la solution aqueuse colloïdale de germes d'or avec tensioactif et par l'eau présente dans le mélange de solvants eau+DMSO d'incubation.

3. Procédé selon l'une des revendications 1 à 2, **caractérisé en ce que** le ratio entre le volume de DMSO et le volume total d'eau est inférieur ou égal à 0.33. le volume total de l'eau étant le volume apporté par la solution aqueuse colloïdale de germes d'or avec tensioactif et par l'eau présente dans le mélange de solvants eau+DMSO d'incubation.

4. Procédé selon l'une des revendications 1 à 2, **caractérisé en ce que** le ratio entre le volume de DMSO et le volume total d'eau est de 1, le volume total de l'eau étant le volume apporté par la solution aqueuse colloïdale de germes d'or avec tensioactif et par l'eau présente dans le mélange de solvants eau+DMSO d'incubation.

5. Procédé selon l'une des revendications 1 à 2, **caractérisé en ce que** le ratio entre le volume DMSO et le volume total d'eau est de 1.5, le volume total de l'eau étant le volume apporté par la solution aqueuse colloïdale de germes d'or avec tensioactif et par l'eau présente dans le mélange de solvants eau+DMSO d'incubation.

6. Procédé selon la revendication 1, **caractérisé en ce que** le ratio entre le volume de DMSO et le volume total d'eau est inférieur à 10 et supérieur à 2, le volume total de l'eau étant le volume apporté par la solution aqueuse colloïdale de germes d'or avec tensioactif et par l'eau présente dans le mélange de solvants eau+DMSO d'incubation.

7. Procédé selon la revendication 6, **caractérisé en ce que** le ratio entre le volume de DMSO et le volume total d'eau est supérieur ou égal à 4, le volume total de l'eau étant le volume apporté par la solution aqueuse colloïdale de germes d'or avec tensioactif et par l'eau présente dans le mélange de solvants eau+DMSO d'incubation.

8. Procédé de synthèse de nanoparticules cœur-coquille selon l'une des revendications précédentes 1 à 7, **caractérisé en ce que** l'étape d'ajout de tensioactif a lieu après une première durée optimale d'incubation allant de quelques minutes à une heure et déterminée par spectroscopie, permettant de contrôler l'assemblage des germes d'or et d'obtenir soit un germe d'or par coquille d'argent, soit deux germes d'or par coquille d'argent.

9. Procédé selon l'une des revendications 1 à 8, **caractérisé en ce que** l'étape d'extraction est réalisée par centrifugation.

10. Procédé selon l'une quelconque des revendications précédentes, **caractérisé en ce que** le tensioactif est choisi parmi la liste suivante : du chlorure de cetyltrimethylammonium (CTAC), du bromure de cetyltrimethylammonium (CTAB) ou du benzyldimethylhexadecylammonium chloride (BDAC).

11. Procédé selon l'une quelconque des revendications précédentes, **caractérisé en ce que**, après l'étape d'extraction, le procédé présente une nouvelle étape d'ajout d'un précurseur d'argent et d'un réducteur, sur les nanoparticules, pour réaliser une surcroissance d'argent.

12. Procédé selon l'une quelconque des revendications précédentes, **caractérisé en ce que** le réducteur est une solution d'acide ascorbique (AA) et de tensioactif, et **en ce que** le précurseur d'argent est du nitrate d'argent.

13. Nanoparticules cœur-coquille or-argent réalisées à partir de germes d'or de forme allongée, obtenu par le procédé défini selon l'une des revendications précédentes 1 à 12, et présentant des traces de DMSO visibles par spectroscopie.

14. Nanoparticules cœur-coquille or-argent selon la revendication 13 **caractérisées en ce que** les nanoparticules cœur-coquille or-argent présentent chacune au moins deux germes d'or par cœur, encapsulés dans la même coquille d'argent enveloppant le coeur.

15. Nanoparticules cœur-coquille or-argent selon la revendication 14, **caractérisées en ce que**, pour chaque nanoparticule, les germes d'or sont disposés tête contre tête dans la même coquille d'argent.

16. Nanoparticules cœur-coquille or-argent selon la revendication 14, **caractérisées en ce que**, pour chaque nanoparticule, les germes d'or sont disposés face contre face dans la même coquille d'argent.

17. Nanoparticules cœur-coquille or-argent selon l'une des revendications 14 à 16, **caractérisées en ce que** les germes d'or sont des nano bâtonnets.

18. Nanoparticules cœur-coquille or-argent selon la revendication 17, **caractérisées en ce que** les nano bâtonnets ont un rapport d'aspect moyen entre 2 et 5.

19. Substrat solide pour Spectroscopie Raman Exaltée de Surface (SERS) comprenant des nanoparticules cœur-coquille or-argent issues de l'une quelconque des revendications 13 à 18 les nanoparticules étant auto-assemblées en réseau 3D, structure 2D sur des surfaces supérieures à 10µm², avantageusement supérieures à 40 µm², pour chaque réseau 2D ou 3D.

20. Substrat solide pour Spectroscopie Raman Exaltée de Surface (SERS) comprenant des nanoparticules cœur-coquille or-argent issues de l'une quelconque des revendications 13 à 18 les nanoparticules étant auto-assemblées en chaine 1D, les chaines 1D présentent des dimensions caractéristiques allant de 2 à 3µm.

21. Application du substrat selon l'une des revendications 19 ou 20 à la détection d'analytes, tels que des polluants organiques.

22. Application selon la revendication 21 l'analyte étant l'atrazine, les nanoparticules cœur-coquille or-argent étant utilisées avec de la béta- cyclodextrine (CAS 7585-39-9) ou alpha-cyclodextrine (CAS 10016-20-3).

23. Application selon la revendication 21 l'analyte étant choisi parmi la liste suivante : le thiram (CAS 137-26-8), le phosmet (CAS 732-11-6), le malathion (CAS 121-75-5), la (4,4')-BPE (CAS 13362-78-2), l'acide 4-mercaptobenzoïque (CAS 1074-36-8).

## Patentansprüche

1. Syntheseverfahren von Nanopartikeln mit gold-silberner Herzschale ausgehend von einer kolloidalen wässerigen Lösung aus Goldkeimen mit Tensid, wobei die Nanopartikel mit gold-silberner Herzschale ausgehend von anisotropen Goldkeimen realisiert sind, **dadurch gekennzeichnet, dass** das Verfahren sukzessive umfasst:
- einen Inkubationsschritt der kolloidalen wässerigen Lösung, die Goldkeime mit Tensiden umfasst, in einer Mischung aus Lösungsmitteln Wasser und DMSO während einer ersten bestimmten Dauer zum Ändern der Organisation des Tensids und der Zusammenstellung der Goldkeime;
- einen Hinzufügungsschritt eines Tensids in der vorherigen resultierenden Mischung;
- einen Erwärmungsschritt der resultierenden Mischung während einer zweiten bestimmten Dauer;
- einen Hinzufügungsschritt in der resultierenden Mischung eines Silbervorläufers und eines Reduktionsmittels zum Realisieren der Silberaufbringung auf den Goldkeimen in einem genannten Hauptschritt während einer bestimmten dritten Dauer;
- einen Extraktionsschritt der Nanopartikel.

2. Verfahren gemäß Anspruch 1, **dadurch gekennzeichnet, dass** das Verhältnis zwischen dem DMSO-Volumen und dem Wasser-Gesamtvolumen geringer ist als 2 und größer als 0.1.2, wobei das Wasser-Gesamtvolumen das Volumen ist, das von der kolloidalen wässerigen Lösung aus Goldkeimen mit Tensid und von dem Wasser, das in der Lösungsmittelmischung Wasser + Inkubations-DMSO vorhanden ist, eingebracht wird.

3. Verfahren gemäß einem der Ansprüche 1 bis 2, **dadurch gekennzeichnet, dass** das Verhältnis zwischen dem DMSO-Volumen und dem Wasser-Gesamtvolumen geringer als oder gleich 0,33.2 ist, wobei das Wasser-Gesamtvolumen das Volumen ist, das von der kolloidalen wässerigen Lösung aus Goldkeimen mit Tensid und von dem Wasser, das in der Lösungsmittelmischung Wasser + Inkubations-DMSO vorhanden ist, eingebracht wird.

4. Verfahren gemäß einem der Ansprüche 1 bis 2, **dadurch gekennzeichnet, dass** das Verhältnis zwischen dem DMSO-Volumen und dem Wasser-Gesamtvolumen 1 beträgt, wobei das Wasser-Gesamtvolumen das Volumen ist, das von der kolloidalen wässerigen Lösung aus Goldkeimen mit Tensid und von dem Wasser, das in der Lösungsmittelmischung Wasser + Inkubations-DMSO vorhanden ist, eingebracht wird.

5. Verfahren gemäß einem der Ansprüche 1 bis 2, **dadurch gekennzeichnet, dass** das Verhältnis zwischen dem DMSO-Volumen und dem Wasser-Gesamtvolumen 1,5 beträgt, wobei das Wasser-Gesamtvolumen das Volumen ist, das von der kolloidalen wässerigen Lösung aus Goldkeimen mit Tensid und von dem Wasser, das in der Lösungsmittelmischung Wasser + Inkubations-DMSO vorhanden ist, eingebracht wird.

6. Verfahren gemäß Anspruch 1, **dadurch gekennzeichnet, dass** das Verhältnis zwischen dem DMSO-Volumen und dem Wasser-Gesamtvolumen geringer ist als 10 und höher ist als 2, wobei das Wasser-Gesamtvolumen das Volumen ist, das von der kolloidalen wässerigen Lösung aus Goldkeimen mit Tensid und von dem Wasser, das in der Lösungsmittelmischung Wasser + Inkubations-DMSO vorhanden ist, eingebracht wird.

7. Verfahren gemäß Anspruch 6, **dadurch gekennzeichnet, dass** das Verhältnis zwischen dem DMSO-Volumen und dem Wasser-Gesamtvolumen höher als oder gleich 4 ist, wobei das Wasser-Gesamtvolumen das Volumen ist, das von der kolloidalen wässerigen Lösung aus Goldkeimen mit Tensid und von dem Wasser, das in der Lösungsmittelmischung Wasser + Inkubations-DMSO vorhanden ist, eingebracht wird.

8. Syntheseverfahren von Nanopartikeln mit Herzschale gemäß einem der voranstehenden Ansprüche 1 bis 7, **dadurch gekennzeichnet, dass** der Hinzufügungsschritt des Tensids nach einer ersten optimalen Inkubationsdauer stattfindet, die von einigen Minuten bis zu einer Stunde dauert und per Spektroskopie bestimmt wird, was das Kontrollieren der Zusammenstellung von Goldkeimen und das Erhalten entweder eines Goldkeims per Silberschale oder von zwei Goldkeimen per Silberschale ermöglicht.

9. Verfahren gemäß einem der Ansprüche 1 bis 8, **dadurch gekennzeichnet, dass** der Extraktionsschritt per Zentrifugieren realisiert wird.

10. Verfahren gemäß irgendeinem der voranstehenden Ansprüche, **dadurch gekennzeichnet, dass** das Tensid aus der folgenden Liste ausgewählt wird: Cetyltrimethylammonium-Chlorid (CTAC), Cetyltrimethylammonium-Bromid (CTAB) oder Benzyldimethylhexadecylammonium-Chlorid (BDAC).

11. Verfahren gemäß irgendeinem der voranstehenden Ansprüche, **dadurch gekennzeichnet, dass** das Verfahren nach dem Extraktionsschritt einen neuen Hinzufügungsschritt eines Silbervorläufers und eines Reduktionsmittels auf den Nanopartikeln umfasst, um ein Silber-Überwachstum zu realisieren.

12. Verfahren gemäß irgendeinem der voranstehenden Ansprüche, **dadurch gekennzeichnet, dass** das Reduktionsmittel eine Lösung aus Ascorbinsäure (AA) und Tensid ist und dass der Silbervorläufer Silbernitrat ist.

13. Gold-silberne Herzschalen-Nanopartikel ausgehend aus Goldkeimen in länglicher Form, die von dem gemäß den voranstehenden Ansprüchen 1 bis 12 definierten Verfahren erhalten werden und per Spektroskopie sichtbare DMSO-Spuren aufweisen.

14. Gold-silberne Herzschalen-Nanopartikel gemäß Anspruch 13, **dadurch gekennzeichnet, dass** die gold-silbernen Herzschalen-Nanopartikel jeweils wenigstens zwei Goldkeime pro Herz aufweisen, die in derselben, das Herz umgebenden Silberschale verkapselt sind.

15. Gold-silberne Herzschalen-Nanopartikel gemäß Anspruch 14, **dadurch gekennzeichnet, dass** die Goldkeime für jeden Nanopartikel in derselben Silberschale Kopf gegen Kopf angeordnet sind.

16. Gold-silberne Herzschalen-Nanopartikel gemäß Anspruch 14, **dadurch gekennzeichnet, dass** die Goldkeime für jeden Nanopartikel in derselben Silberschale Seite gegen Seite angeordnet sind.

17. Gold-silberne Herzschalen-Nanopartikel gemäß einem der Ansprüche 14 bis 16, **dadurch gekennzeichnet, dass** die Goldkeime Nanostäbchen sind.

18. Gold-silberne Herzschalen-Nanopartikel gemäß Anspruch 17, **dadurch gekennzeichnet, dass** die Nanostäbchen ein durchschnittliches Aspektverhältnis zwischen 2 und 5 aufweisen.

19. Solides Substrat für Erhöhte Oberflächen-Ramanspektroskopie (SERS), umfassend silber-goldene Herzschalen-Nanopartikel, die aus irgendeinem der Ansprüche 13 bis 18 hervorgegangen sind, wobei die Nanopartikel im 3D-Netz selbst zusammengestellt werden, einer 2D-Struktur auf den Flächen, die größer sind als 10 µm², vorteilhaft größer als 40 µm², für jedes 2D- der 3D-Netz.

20. Festes Substrat für Erhöhte Oberflächen-Ramanspektroskopie (SERS), umfassend silber-goldene Herzschalen-Nanopartikel, die aus irgendeinem der Ansprüche 13 bis 18 hervorgegangen sind, wobei die Nanopartikel in einer 1D-Kette selbst zusammengestellt sind, wobei die 1D-Ketten von 2 bis 3 µm² reichende charakteristische Merkmale aufweisen.

21. Anwendung des Substrats gemäß einem der Ansprüche 19 oder 20 auf das Erkennen von Analyten, wie z. B. organischen Kontaminanten.

22. Anwendung gemäß Anspruch 21, wobei das Analyt Atrazin ist, die gold-silbernen Herzschalen-Nanopartikel mit dem Beta-Cyclodextrin (CAS 7585-39-9) oder Alpha-Cyclodextrin (CAS 10016-20-3) verwendet sind.

23. Anwendung gemäß Anspruch 21, wobei das Analyt aus der folgenden Liste ausgewählt ist: Thiram (CAS 137-26-8), Phosmet (CAS 732-11-6), Malathion (CAS 121-75-5), (4,4')-BPE (CAS 13362-78-2), 4-Mercaptoben-Benzoesäure (CAS 1074-36-8).

## Claims

1. A method for synthesising gold-silver core-shell nanoparticles, from a colloidal aqueous solution of gold seeds with a surfactant, the gold-silver core-shell nanoparticles being made from anisotropic gold seeds, **characterised in that** the method successively comprises:
- a step of incubating the colloidal aqueous solution containing gold seeds with a surfactant, into a water and DMSO solvent mixture, for a first given duration; to modify organisation of the surfactant and assembling of gold seeds;
- a step of adding a surfactant into the previous resulting mixture;
- a step of heating the resulting mixture for a second given duration;
- a step of adding a silver precursor and a reducing agent into the resulting mixture, to perform silver deposition onto the gold seeds, in a so-called main step, for a third given duration;
- a step of extracting nanoparticles.

2. The method according to claim 1, **characterised in that** the ratio of the DMSO volume to the total water volume is lower than 2 and greater than 0.1, the total water volume being the volume brought by the colloidal aqueous solution of gold seeds with a surfactant and by water present in the incubating water + DMSO solvent mixture.

3. The method according to one of claims 1 to 2, **characterised in that** the ratio of the DMSO volume to the total water volume is lower than or equal to 0.33, the total water volume being the volume brought by the colloidal aqueous solution of gold seeds with a surfactant and by water present in the incubating water + DMSO solvent mixture.

4. The method according to one of claims 1 to 2, **characterised in that** the ratio of the DMSO volume to the total water volume is 1, the total water volume being the volume brought by the colloidal aqueous solution of gold seeds with a surfactant and by water present in the incubating water + DMSO solvent mixture.

5. The method according to one of claims 1 to 2, **characterised in that** the ratio of the DMSO volume to the total water volume is 1.5, the total water volume being the volume brought by the colloidal aqueous solution of gold seeds with a surfactant and by water present in the incubating water + DMSO solvent mixture.

6. The method according to claim 1, **characterised in that** the ratio of the DMSO volume to the total water volume is lower than 10 and greater than 2, the total water volume being the volume brought by the colloidal aqueous solution of gold seeds with a surfactant and by water present in the incubating water + DMSO solvent mixture.

7. The method according to claim 6, **characterised in that** the ratio of the DMSO volume to the total water volume is greater than or equal to 4, the total water volume being the volume brought by the colloidal aqueous solution of gold seeds with a surfactant and by water present in the incubating water + DMSO solvent mixture.

8. The method for synthesising core-shell nanoparticles according to one of the previous claims 1 to 7, **characterised in that** the step of adding a surfactant takes place after a first optimum incubating duration ranging from a few minutes to one hour and determined by spectroscopy, for controlling the assembling of gold seeds and for obtaining either one gold seed per silver shell, or two gold seeds per silver shell.

9. The method according to one of claims 1 to 8, **characterised in that** the extracting step is performed by centrifugation.

10. The method according to any of the previous claims, **characterised in that** the surfactant is selected from the following list: cetyltrimethylammonium chloride (CTAC), cetyltrimethylammonium bromide (CTAB) or benzyldimethylhexadecylammonium chloride (BDAC).

11. The method according to any of the previous claims, **characterised in that**, after the extracting step, the method has a new step of adding a silver precursor and a reducing agent, on the nanoparticles, to perform silver overgrowth.

12. The method according to any of the previous claims, **characterised in that** the reducing agent is an ascorbic acid (AA) and surfactant solution, and **in that** the silver precursor is silver nitrate.

13. Gold-silver core-shell nanoparticles made from elongate-shaped gold seeds, obtained by the method defined according to one of the previous claims 1 to 12, and having DMSO traces visible by spectroscopy.

14. The gold-silver core-shell nanoparticles according to claim 13, **characterised in that** the gold-silver core-shell nanoparticles each have at least two gold seeds per core, encapsulated into the same silver shell wrapping the core.

15. The gold-silver core-shell nanoparticles according to claim 14, **characterised in that**, for each nanoparticle, the gold seeds are disposed head to head in the same silver shell.

16. The gold-silver core-shell nanoparticles according to claim 14, **characterised in that**, for each nanoparticle, the gold seeds are disposed face to face in the same silver shell.

17. The gold-silver core-shell nanoparticles according to one of claims 14 to 16, **characterised in that** the gold seeds are nanorods.

18. The gold-silver core-shell nanoparticles according to claim 17, **characterised in that** the nanorods have a mean aspect ratio between 2 and 5.

19. A solid substrate for Surface Enhanced Raman Spectroscopy (SERS) comprising gold-silver core-shell nanoparticles from any of claims 13 to 18, the nanoparticles being self-assembled as 2D structure, 3D-array on surface areas greater than 10µm², advantageously greater than 40µm², for each 2D or 3D array.

20. The solid substrate for surface enhanced Raman spectroscopy (SERS) comprising gold-silver core-shell nanoparticles from any of claims 13 to 18, the nanoparticles being self-assembled as a 1D-chain, the 1D-chains having characteristic dimensions ranging from 2 to 3µm.

21. An application of the substrate according to one of claims 19 or 20 for detecting analytes, such as organic pollutants.

22. The application according to claim 21, the analyte being atrazine, the gold-silver core-shell nanoparticles being used with beta-cyclodextrin (CAS 7585-39-9) or alpha-cyclodextrin (CAS 10016-20-3).

23. The application according to claim 21, the analyte being selected from the following list: thiram (CAS 137-26-8), phosmet (CAS 732-11-6), malathion (CAS 121-75-5), (4,4')-BPE (CAS 13362-78-2), 4-mercaptobenzoic acid (CAS 1074-36-8).
